(19) Europäisches Patentamt

European Patent Office

Office européen des brevets

(11) **EP 1 331 202 A2**

(12) **EUROPEAN PATENT APPLICATION**

(43) Date of publication:
**30.07.2003 Bulletin 2003/31**

(51) Int Cl.[7]: **C01B 31/02**, C23C 16/26, H01L 51/40, H01L 51/30

(21) Application number: **02257772.0**

(22) Date of filing: **08.11.2002**

(84) Designated Contracting States:
**AT BE BG CH CY CZ DE DK EE ES FI FR GB GR IE IT LI LU MC NL PT SE SK TR**
Designated Extension States:
**AL LT LV MK RO SI**

(30) Priority: **22.01.2002 KR 2002003688**

(71) Applicant: **Samsung SDI Co. Ltd.**
**Suwon-city, Kyungki-do (KR)**

(72) Inventors:
- **Han, In-Taek**
  **Seocho-gu, Seoul (KR)**
- **Park, Young-jun**
  **Paldal-gu, Suwon-city, Kyeoungki-do (KR)**

(74) Representative: **Kyle, Diana**
**Elkington and Fife**
**Prospect House**
**8 Pembroke Road**
**Sevenoaks, Kent TN13 1XR (GB)**

(54) **Electronic device having an electrode made of metal on which carbon nanotubes are deposited**

(57) An electronic device having an electrode made of metal that reacts easily with carbon is provided. In the electronic device, the electrode on which carbon nanotubes are deposited by a chemical vapor deposition method using a reactant gas containing carbon and oxygen, is made of a metal generating less reaction enthalpy when reacting with carbon than when reacting with oxygen. Since the electrode is made of a metal which reacts with carbon faster than oxygen, a carbonized metal layer is formed on the electrode, thereby preventing the electrode from being oxidized. Accordingly, the carbon nanotubes can be easily deposited on the electrode.

**Description**

The present invention relates to an electronic device, and more particularly, to an electronic device having an electrode which is proper to a case where carbon nanotubes are deposited on the electrode by chemical vapor deposition.

Due to peculiar structural and electrical characteristics, carbon nanotubes are applied to a variety of types of electrode devices. For example, they can be applied to the fields of electron emitters, substances containing hydrogen, cathode materials for secondary cells, catalyzers, and sensors. In addition, more applications of carbon nanotubes are under development.

In manufacturing electron devices using carbon nanotubes, a method using carbon nanotubes in the form of powder or paste or a method of directly depositing carbon nanotubes on a substrate using chemical vapor deposition is used.

In a method of manufacturing electron devices using carbon nanotube powder or paste, laser ablation or arc discharge is performed on carbon nanotubes to obtain carbon nanotube powder, the carbon nanotube powder is mixed with conductive or nonconductive paste, and then printing is performed.

A method using paste is inferior to a method using chemical vapor deposition in a characteristic such as selective deposition or alignment. Accordingly, it is predicted that the method using chemical vapor deposition will be widely used in manufacturing electronic devices.

Representative chemical vapor deposition methods are a thermal chemical vapor deposition method and a plasma chemical vapor deposition method. The plasma chemical vapor deposition method is advantageous in synthesizing carbon nanotubes at a lower temperature than in a electric discharge method or a laser deposition method. The thermal chemical vapor deposition method is advantageous in synthesizing carbon nanotubes on a large area and synthesizing carbon nanotubes of high quality.

In the above chemical vapor deposition methods, methane ($CH_4$), acetylene ($C_2H_2$), or carbon monoxide (CO) is used as a reactant gas for deposition of carbon nanotubes. This reactant gas is mixed with an etching gas such as hydrogen ($H_2$) or ammonia ($NH_3$).

When methane is used as a reactant gas in a case using high-energy plasma, carbon nanotubes of good quality can be generated. When acetylene is used as a reactant gas, carbon nanotubes can be deposited at a low temperature.

Carbon monoxide allows the hydrogen impurity content of carbon nanotubes to be reduced so that carbon nanotubes of good quality can be deposited at a low temperature. However, carbon monoxide competes with oxygen atoms or radicals, which are generated during manufacturing of carbon nanotube, for chemical reaction with a metal or other carbon molecules, thereby oxidizing the metal or generating a product such as carbon dioxide. The surface of the metal oxidized by carbon monoxide is reduced in electrical conductivity, thereby disturbing the correct operation of electronic devices.

In other words, when gas such as carbon monoxide, carbon dioxide ($CO_2$), methyl alcohol ($CH_3OH$), or ethyl alcohol ($C_2H_5OH$) containing oxygen is used as a reactant gas in a conventional chemical vapor deposition apparatus, the reactant gas reacts with a metal forming electrodes and oxidizes it, thereby decreasing electrical conductivity of the electrodes. Consequently, performance of electronic devices is decreased.

To solve the above-described problems, it is an object of the present invention to provide an electronic device having an electrode, in which the electrical conductivity of the electrode is maintained constant and carbon nanotubes of good quality are formed on the electrode when the carbon nanotubes are deposited on the electrode using a chemical vapor deposition method.

To achieve the above object of the present invention, in one aspect, there is provided an electronic device having an electrode on which carbon nanotubes are deposited by a chemical vapor deposition method using a reactant gas containing carbon and oxygen. The electrode is made of a metal generating less reaction enthalpy when reacting with carbon than when reacting with oxygen.

Preferably, the metal is Ti or Mo.

Preferably, the metal reacts with carbon, forming a carbonized metal.

The reactant gas is for example, carbon monoxide, carbon dioxide, methyl alcohol or ethyl alcohol.

In another aspect, there is provided an electronic device having an electrode on which carbon nanotubes are deposited by a chemical vapor deposition method, the electron having a carbonized metal layer formed on a surface thereof. The carbonized metal layer prevents the electrode from being oxidized.

Preferably, the metal is Ti or Mo.

Since the present invention uses a metal, which generates less reaction enthalpy when reacting with carbon than when reacting with oxygen, for an electrode, the metal of the electrode reacts with carbon prior to oxygen to form a carbonized metal layer on the surface of the electrode when a reactant gas containing carbon and oxygen is injected in a chemical vapor deposition apparatus. Due to the carbonized metal layer, oxygen cannot permeate into the electrode. Accordingly, the electrode is prevented from being oxidized, thereby maintaining the electrical conductivity of the electrode constant and increasing the yield of carbon nanotubes.

The above object and advantages of the present invention will become more apparent by describing in detail a preferred embodiment thereof with reference to the attached drawings in which:

FIG. 1 is a diagram of an electronic device having electrodes according to an embodiment of the present invention;

FIG. 2 is a diagram for explaining a method of manufacturing an electronic device having electrodes according to the embodiment of the present invention using plasma chemical vapor deposition;

FIG. 3 is a diagram for explaining a method of manufacturing an electronic device having electrodes according to the embodiment of the present invention using thermal chemical vapor deposition;

FIG. 4 is a graph of changes in an atom concentration versus sputter time after a chrome electrode is exposed to carbon nanotube deposition conditions;

FIG. 5A is a graph of changes in an atom concentration versus sputter time after an aluminum electrode is exposed to carbon nanotube deposition conditions;

FIG. 5B is a graph of count/second (C/S) versus binding energy after an aluminum electrode is exposed to carbon nanotube deposition conditions; and

FIG. 6 is a graph of changes in an atom concentration versus sputter time after a molybdenum electrode is exposed to carbon nanotube deposition conditions.

Hereinafter, an electronic device having electrodes according to the embodiment of the present invention will be described in detail with reference to the attached drawings.

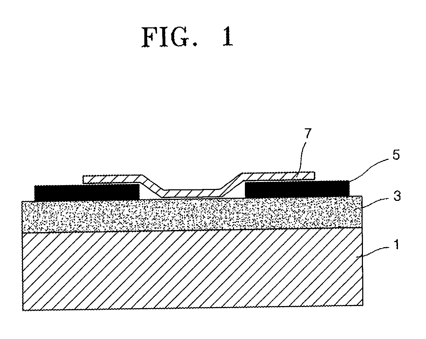

FIG. 1 is a diagram of an electronic device having electrodes according to an embodiment of the present invention. Referring to FIG. 1, an insulation layer 3 is deposited on a substrate 1, two metal electrodes 5 in the form of foils are disposed to be separated from each other by a predetermined space at both sides on the surface of the insulation layer 3, and a carbon nanotube layer 7 connects the two metal electrodes 5.

The structure is a most simple current-voltage (I-V) device if silicon is not doped with impurities and is a field-effect transistor (FET) if silicon is doped with P-type or N-type impurities.

The metal electrodes 5 of the electronic device are made of a metal such as titanium (Ti) or molybdenum (Mo). The metal generates less reaction enthalpy when reacting with carbon than when reacting with oxygen, so the metal reacts with carbon at higher speed than oxygen.

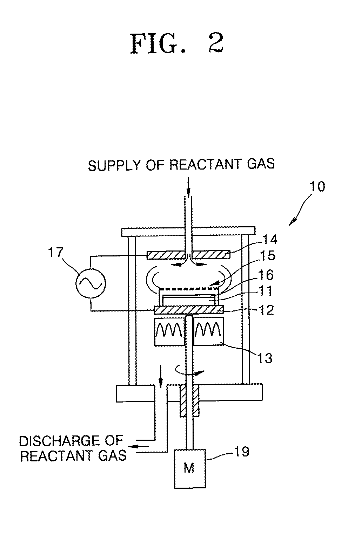

FIG. 2 is a diagram for explaining a method of manufacturing an electronic device having electrodes according to the embodiment of the present invention using plasma chemical vapor deposition. Referring to FIG. 2, in a plasma chemical vapor deposition apparatus, an upper electrode 14 and a lower electrode 12 are provided, and a substrate 11 on which a catalytic metal layer is formed is positioned on the lower electrode 12. A thermal resistance heater 13 positioned below the lower electrode 12 supplies heat to the substrate 11. A filament 15 is disposed between the upper electrode 14 and the lower electrode 12 to supply energy necessary for decomposing a reactant gas or synthesizing carbon nanotubes. A motor 19 rotates the lower electrode 12 on which the substrate 11 is positioned.

A metal electrode 16 of an electron device to be manufactured is positioned on the surface of the catalytic metal layer on the substrate 11. The metal electrode 16 is made of a metal generating larger reaction enthalpy when reacting with carbon than when reacting with oxygen. Here, the electronic device to be manufactured may have another layer having a different function, for example, an insulation layer, between the substrate 11 and the metal electrode 16.

An RF power supply 17 is connected to the upper and lower electrodes 14 and 12 to supply electrical energy. A pipe for injecting a reactant gas is connected to the center of the upper electrode 14 so that a reactant gas such as carbon monoxide, methane, acetylene, or hydrogen is supplied to a reaction chamber 10.

When RF power is supplied under a state in which a predetermined pressure is maintained at a temperature of no greater than about 660EC after an etching gas such as ammonia gas or hydrogen gas is injected into the reaction chamber 10, the surface of the metal electrode 16 on the substrate 11 is etched by plasma generated from the etching gas, thereby forming catalytic corpuscles in the forms of fine grains on the surface of the metal electrode 16. Carbon nanotubes are synthesized to be vertically arranged on the catalytic corpuscles.

A glass, quartz, silicon, or alumina ($Al_2O_3$) substrate may be used as the substrate 11.

The metal electrode 16 of an electronic device may be made of a metal such as Ti, Mo, or iron (Fe) that reacts with carbon at higher speed than oxygen because it generates less reaction enthalpy when reacting with carbon than when reacting with oxygen.

Formula (1) is a chemical reaction formula illustrating the production of a carbonized metal when a metal reacts with carbon monoxide. Formula (2) illustrates a chemical reaction for producing an oxidized metal.

$$2M + 2CO \rightarrow 2MC + O_2 \qquad (1)$$

$$2M + 2CO \rightarrow 2MO + 2C \qquad (2)$$

In the case of Ti, the binding energy of TiO is 672.4 kJ/mol, the binding energy of TiC is 423 kJ/mol, a reaction enthalpy according to Formula (1) is -1307.1 kJ, and a reaction enthalpy according to Formula (2) is -808.2 kJ, so it can be inferred that the reaction according to Formula (1) is more dominant than the reaction according to Formula (2).

In the case of Mo, the binding energy of MoO is 560.2 kJ/mol, the binding energy of MoC is 481 kJ/mol, a reaction enthalpy according to Formula (1) is -1191 kJ, and a reaction enthalpy according to Formula (2) is -1032 kJ, so it can be inferred that the reaction according to Formula (1) is more dominant than the reaction according to Formula (2).

However, in the case of Cr, while the binding energy of CrO is 429.3 kJ/mol, the binding energy of CrC is much higher than 429.3 kJ/mol, so the reaction according to Formula (2) is more dominant than the reaction according to Formula (1).

Accordingly, when gas such as carbon monoxide, carbon dioxide, methyl alcohol, or ethyl alcohol containing oxygen is used as a reaction gas, a carbonized metal such as carbon titanium, carbon molybdenum, or iron carbide is formed on the surface of a metal, thereby preventing the metal from contacting oxygen.

Internal energy decreases, resulting in a negative reaction enthalpy when chemical reaction is of exothermic type, and increases, resulting in a positive reaction enthalpy when the chemical reaction is of endothermic type. In the present invention, a chemical reaction between carbon and metal and a chemical reaction between oxygen and metal are exothermic reactions, and a decrement in internal energy in the chemical reaction between carbon and metal is larger than a decrement in internal energy in the chemical reaction between oxygen and metal, so reaction enthalpy in the chemical reaction between carbon and metal is less than that in the chemical reaction between oxygen and metal. In other words, more heat is generated when a carbonized metal is produced by the reaction between carbon and metal than when an oxidized metal is produced by the reaction between oxygen and metal. Therefore, it can be inferred that a carbonized metal is safer than an oxidized metal.

An electronic device having an electrode made of a metal according to the embodiment of the present invention may be manufactured by a thermal chemical vapor deposition method.

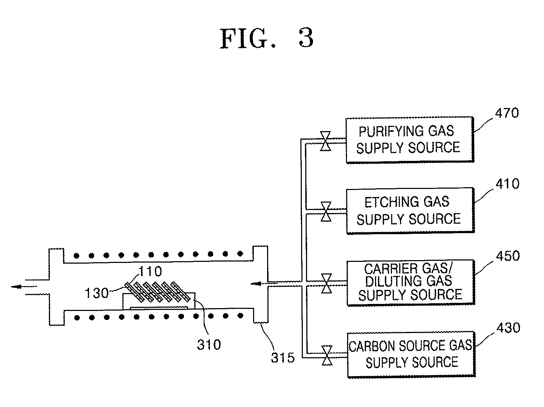

Referring to FIG. 3, substrates 130 having electrodes 110 are arranged on a boat 310 of a thermal chemical vapor deposition apparatus to be separated from one another by a predetermined space in a line, and the boat 310 is loaded within a reaction furnace 315. Thereafter, the temperature of the reaction furnace 315 is raised to a process temperature, and an etching gas and a reactant gas are injected to the reaction furnace 315 to deposit carbon nanotubes on the electrodes 110.

Descriptions of the substrates 130, the electrodes 110, and the reactant gas are the same as those in the plasma chemical vapor deposition method, and thus they will be omitted.

According to the present invention, when an electronic device such as a transistor or a field emitter display (FED) is manufactured by a thermal chemical vapor deposition method or a plasma chemical vapor deposition method, the electrode 16 or 110 is made of a metal such as Ti, Mo, or Fe that reacts with carbon better than with oxygen, so a carbonized metal layer is formed on the electrode 16 or 110. Accordingly, the electrode 16 or 110 is prevented from being oxidized during formation of carbon nanotubes. Since electrical conductivity is maintained constant, an electronic device can be easily manufactured. Therefore, an electronic device having good performance can be manufactured.

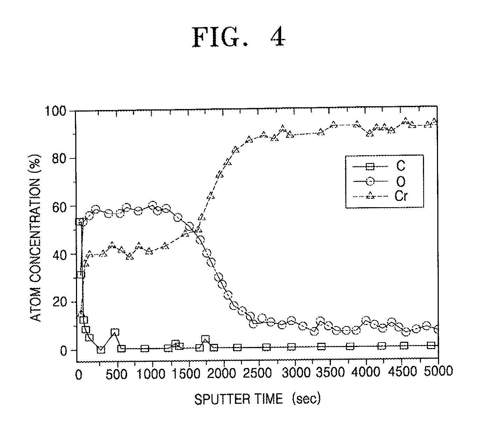

FIG. 4 is a graph showing a change in an atom concentration (%) with respect to a chrome (Cr) electrode, which has been exposed to the conditions of carbon nanotube manufacturing using a mixed gas of carbon monoxide and hydrogen as a reactant gas, in the form of an Auger electron spectrum.

Referring to FIG. 4, as the sputter time elapses 1500 sec, a Cr-atom concentration increases while an oxygen (O)-atom concentration decreases. A carbon (C)-atom concentration is almost constant.

Since chrome reacts with oxygen prior to carbon so as to form chrome oxide ($CrO_x$), a Cr-atom concentration is small to a predetermined depth from the surface but increases as the depth is deeper into the inside of the chrome electrode. In contrast, oxygen which is familiar with chrome is adsorbed to the surface of the chrome electrode much, so an O-atom concentration is high to a predetermined depth from the surface but decreases as the depth is deeper into the inside of the chrome electrode. Carbon hardly reacts with chrome, so a C-atom concentration is maintained nearly constant.

It can be seen from the graph that chrome is more familiar with oxygen than carbon, so it can be inferred that chrome is inappropriate for the electrode.

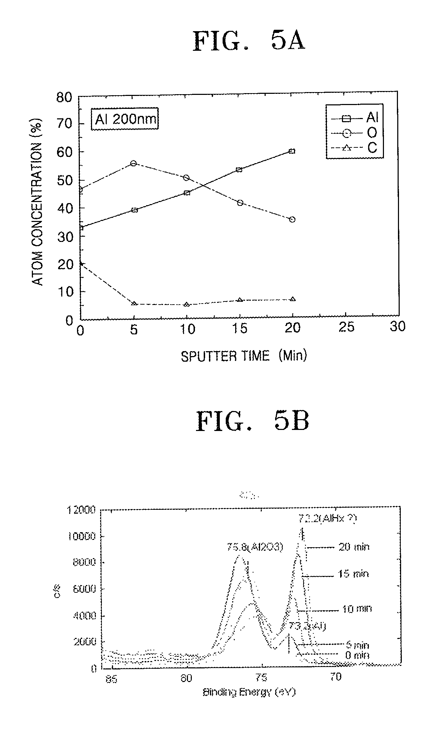

FIG. 5A is a graph showing a change in an atom concentration with respect to an aluminum (Al) electrode, which has been exposed to the conditions of carbon nanotube manufacturing using a mixed gas of carbon monoxide and hydrogen as a reactant gas, in the form of an X-ray photoelectron spectrum.

Referring to FIG. 5A, an Al-atom concentration increases while an O-atom concentration decreases as a depth from the surface of the aluminum electrode is deeper.

Aluminum reacts with oxygen or hydrogen, thereby producing alumina ($Al_2O_3$) or aluminum hydride ($AlH_x$, for example, $AlH_3$). Referring to FIG. 5, as the depth from the surface of the aluminum electrode is deeper, more aluminum hydride is produced. In other words, it is inferred from the results only shown in FIG. 5A that aluminum mainly reacts with oxygen to produce alumina on the surface of the electrode, but it can be newly inferred from the graph shown in FIG. 5B that aluminum hydride is more produced than alumina. However, aluminum hydride has a low melting point, so aluminum is inappropriate for the electrode.

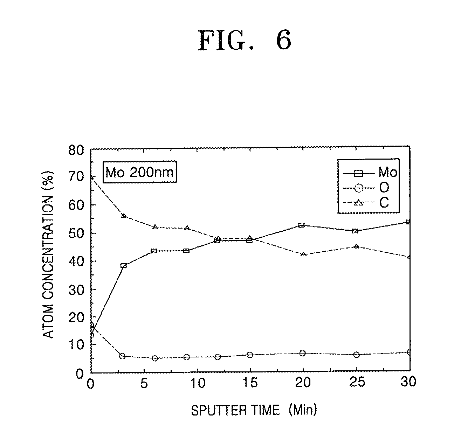

FIG. 6 is a graph showing a change in an atom concentration with respect to a molybdenum (Mo) electrode, which is included in an electron device according to the embodiment of the present invention and which has been exposed to the conditions of carbon nanotube manufacturing using a mixed gas of carbon monoxide and hydrogen as a reactant gas, in the form of an X-ray photoelectron spectrum.

As shown in FIG. 6, as an etching process proceeds, a C-atom concentration decreases while a Mo-atom concentration increases and an O-atom concentration is maintained nearly constant. This is because a molybdenum carbide layer is formed on only the surface of the electrode and a metal property is maintained inside the electrode. It can be inferred from this graph that molybdenum is appropriate for the electrode used in an electronic device according to the embodiment of the present invention.

The following table shows changes in electrical conductivity of different metals. A unit is l/Ω cm.

| Metal | Cr | Mo | Ti | Ni | Al |
|---|---|---|---|---|---|
| Before reaction | 0.2 | 0.4 | 0.3 | 0.4 | 0.2 |
| After reaction | $>10^{-6}$ | 1.2 | 1.0 | 15.7 | 0.6 |

While the electrical conductivity of chrome greatly decreases after reaction in a chemical vapor deposition apparatus, the electrical conductivities of the other metals hardly change. It can be inferred from the above table that electrical energy can be constantly supplied when an electrode is made of one of the four metals except chrome. However, aluminum may sublimate in the form of aluminum hybrid, so it is not appropriate for an electrode.

According to the embodiment of the present invention, in the case of using a reactant gas containing carbon and oxygen in forming carbon nanotubes, an electronic device has an electrode made of a metal that reacts with carbon at higher speed than oxygen because it generates less reaction enthalpy when reacting with carbon than when reacting with oxygen so that a carbonized metal layer is formed on the surface of the electrode to prevent oxidization. Accordingly, carbon nanotubes can be grown on the electronic device under a state in which the electrical conductivity of the electrode is maintained constant, thereby improving the performance of the electronic device.

As described above, according to the present invention, an electronic device has an electrode made of a metal which reacts with carbon better than with oxygen so that a carbonized metal layer is formed on the electrode so as to prevent oxidization of the electrode. As a result, the electrical conductivity of the electrode is maintained constant, thereby allowing carbon nanotubes to be formed by various methods and improving the entire performance of the electronic device.

**Claims**

1. An electronic device having an electrode on which carbon nanotubes are deposited by a chemical vapor deposition method using a reactant gas containing carbon and oxygen, the electrode being made of a metal which generates less reaction enthalpy when reacting with carbon than when reacting with oxygen.

2. The electronic device according to claim 1, wherein the metal is Ti or Mo.

3. The electronic device according to claim 2, wherein the metal is one which reacts with carbon to form a carbonized metal.

4. The electronic device according to claim 1, wherein the reactant gas is carbon monoxide, carbon dioxide, methyl alcohol or ethyl alcohol.

5. An electronic device having an electrode on which carbon nanotubes are deposited by a chemical vapor deposition method, the electrode having a carbonized metal layer formed on a surface thereof, the carbonized metal layer preventing the electrode from being oxidized.

6. The electronic device according to claim 5, wherein the metal is Ti or Mo.

FIG. 1

# FIG. 2

SUPPLY OF REACTANT GAS

10

17

14
15
16
11
12

13

DISCHARGE OF
REACTANT GAS

M    19

# FIG. 3

# FIG. 4

# FIG. 5A

# FIG. 5B

FIG. 6